# EUROPEAN PATENT APPLICATION

(11) **EP 2 109 156 A1**
(43) Date of publication of application: **14.10.2009**
(21) Application number: 07791112.1
(22) Date of filing: 20.07.2007
(51) Int. Cl.: H01L 33/00, C09J 7/02, C09J 11/04, C09J 133/02

(54) **LED LIGHT SOURCE UNIT**

(30) Priority: 30.01.2007 JP 2007019755; 31.05.2007 WO PCT/JP2007/061121
(71) Applicant: Denki Kagaku Kogyo Kabushiki Kaisha, Tokyo 103-8338 (JP)
(72) Inventor: YASHIMA, Katsunori, Shibukawa-shi Gunma 377-8520 (JP); MIYAKAWA, Takeshi, Shibukawa-shi Gunma 377-8520 (JP); MIYATA, Kenji, Shibukawa-shi Gunma 377-8520 (JP); NISHI, Taiki, Shibukawa-shi Gunma 377-8520 (JP); OKAJIMA, Yoshihiko, Tokyo 103-8338 (JP); OKADA, Takuya, Shibukawa-shi Gunma 377-8520 (JP); TAKANO, Keiji, Shibukawa-shi Gunma 377-8520 (JP); MITSUNAGA, Toshikatsu, Omuta-shi Fukuoka 836-8510 (JP)
(74) Representative: Hartz, Nikolai
(86) International application number: PCT/JP2007/064375
(87) International publication number: WO 2008/093440

(57) **Abstract**

To provide an LED light source unit which is excellent in heat dissipation performance, able to prevent damage to LED and bright, and which has a long life.

An LED light source unit comprising a printed board, at least one light emitting diode provided on the printed board, and an adhesive tape for fixing the printed board on the surface of a heat dissipating member, wherein the thermal conductivity of the adhesive tape is from 1 to 4 W/mK, and the withstand voltage between a rear side conductor circuit and a metal housing is at least 1.0 kV.

## Description

### TECHNICAL FIELD

The present invention relates to a light emitting diode (LED) light source unit having a long life, which employs a light emitting diode (LED) as a light source and which is excellent in heat dissipation performance.

### BACKGROUND ART

In e.g. a liquid crystal display device comprising a liquid display element and a backlight, it has been common to use a small size fluorescent tube so-called CCFL (cold cathode fluorescent lamp) as a light source for the backlight.

The above CCFL (cold cathode fluorescent lamp) light source employs such a structure that mercury is sealed in a discharge tube so that ultraviolet rays emitted from mercury excited by discharge will hit a phosphor on a side wall of the cold cathode fluorescent lamp and will be converted to visible light. In consideration of an environmental aspect, recently, it has been desired to use a substitute light source which does not use hazardous mercury.

Recently, an LED light source unit using a light emitting diode (LED) as a light source has been used in various fields.

For example, as a new light source for liquid crystal display devices, one using a light emitting diode (hereinafter sometimes referred to simply as LED) has been proposed. LED provides light with directionality, and especially in a surface-mounted type such as one mounted on e.g. a printed board, light is taken out in one direction. Accordingly, as is different from a conventional structure employing CCFL (cold cathode fluorescent lamp), there is little loss of light, and thus, it is used as a backlight light source of a planar light source system (Patent Document 1).

Reflecting demands for lower price and improvement in luminous efficiency and environment regulations, a backlight using LED as a light source has started to be widely used as a backlight for liquid crystal display devices. At the same time, to meet demands for higher luminance of liquid crystal display devices and enlarging a display area, there has been a progress in increasing the number of LEDs mounted on a printed board and increasing the output in order to improve the amount of luminance.

However, with an LED light source, the luminous efficiency is not high, and when LED emits light, the majority of the input power will be discharged as a heat. When an electric current is applied, LED generates a heat and will be heated to a high temperature by the generated heat. In an extreme case, LED will be destroyed by such heat. Also in the case of a backlight using LED as a power source, such generated heat tends to be accumulated in LED and the substrate on which LED is mounted, and along with the increase of the temperature of LED, the luminous efficiency of LED itself tends to decrease. Besides, if it is attempted to increase the number of LEDs to be mounted or to increase the input power in order to increase the brightness of the backlight, the amount of such heat generation will increase, and it will be important to further remove such heat.

In order to reduce the heat accumulation of an LED-mounted board and to reduce the temperature rise of an LED chip, a mounting metal film on which an LED chip is to be mounted, a driver wire to supply a driving current to the LED chip and a metal film-pattern for the purpose of heat dissipation, are formed on an LED chip-mounting face of an LED-mounted board. Further, it has been proposed that a metal film for heat dissipation is formed on a face opposite to the LED chip-mounting face, and in the thickness direction of the LED chip-mounted board, a metal through-hole is formed to connect a metal pattern on one main face side and a metal film for heat dissipation on the other main face side, so that the heat generated from LED is released to the rear side metal film via the metal through-hole (Patent Document 2).

However, in such a case, the heat dissipation may be good to the rear side metal film of the printed board, but no heat dissipation from the housing located ahead of the rear side metal film is taken into consideration. Accordingly, in a case where LED is continuously operated, there will be a problem such that due to the temperature rise of LED, the luminous efficiency of LED itself tends to deteriorate. Further, there has been a problem that the printed board is likely to get warped by an influence of the heat generation from LED, whereby it tends to be peeled from the adhesive tape, or LED tends to be displaced from the desired position for emission of light, whereby the desired optical characteristics can not be obtained.

Further, a metal base circuit board having an insulating layer made of an inorganic filler-filled epoxy resin formed on a metal plate having a thickness of about 2 mm and having a circuit pattern formed thereon, is used as a circuit board for electronic equipments for automobiles and communication equipments having highly heat-generating electronic components mounted thereon, since it is excellent in heat dissipation performance and electric insulation properties (Patent Documents 3 and 4).

On the other hand, when a metal base circuit board employing a metal base plate having a thickness of about 2 mm is used instead of a printed board, it is possible to obtain good heat dissipation performance without providing metal through-holes or the like. However, there are problems such that the thickness of the board tends to be thick, and it is required to take a larger punching out size than the printed board in view of e.g. electrodes and wiring patterns, whereby the area of the board tends to be large. Further, it is not possible to optionally bend a portion other than the LED-mounted portion, whereby there will be a restriction with respect to e.g. the position where an input terminal is to be formed.

Further, if it is attempted to reduce the thickness of the metal base plate of the above metal base circuit board to have a construction having the punching out size reduced in the same manner as a printed board in view of electrodes and the wiring pattern, there will be a problem such that since no consideration is given for heat dissipation from the housing located ahead from the rear side of the metal base plate, just like in the case of a printed board having through-holes formed therein, if LED is operated continuously, the luminous efficiency of LED itself tends to deteriorate along with the temperature rise of LED. Further, there has been a problem such that even when the metal base circuit board deforms only a little, cracks are likely to form in the insulating layer to a practically unacceptable level, and the LED-mounted portion can not be freely bent.
Patent Document 1: JP-A-2005-293925
Patent Document 2: JP-A-2005-283852
Patent Document 3: JP-A-62-271442
Patent Document 4: JP-A-06-350212

### DISCLOSURE OF THE INVENTION

### OBJECT TO BE ACCOMPLISHED BY THE INVENTION

The present invention has been made to solve the above-mentioned problems of the prior art. Specifically, it is an object of the present invention to improve the heat dissipation performance while maintaining the thickness of an LED-mounted board having an LED power source mounted thereon to be as thin as the conventional level and maintaining the width of the board to be narrow and yet without necessity to form through-holes immediately below LED or to pattern the metal film for heat dissipation on the LED-mounted surface on the mounted-board, and consequently to provide an LED light source unit which is bright and has a long life and which is free from a damage of LED.

### MEANS TO ACCOMPLISH THE OBJECT

Thus, the present invention provides the following:
(1) An LED light source unit comprising a printed board, at least one light emitting diode provided on the printed board, and an adhesive tape for fixing the printed board on the surface of a heat dissipating member, wherein the thermal conductivity of the adhesive tape is from 1 to 4 W/mK, and the withstand voltage between a rear side conductor circuit and a metal housing is at least 1.0 kV.
(2) The LED light source unit according to the above (1), wherein the thickness of the adhesive tape is from 30 to 300 µm.
(3) The LED light source unit according to the above (1), wherein the thickness of the adhesive tape is from 30 to 50 µm.
(4) The LED light source unit according to any one of the above (1) to (3), wherein the adhesive tape comprises from 20 to 45 vol% of a polymer resin material made of a copolymer of (meth)acrylic acid with a monomer copolymerizable with (meth)acrylic acid, and from 40 to 80 vol% of an inorganic filler having a particle size of at most 45 µm and an average particle size of from 0.3 to 30 µm.
(5) The LED light source unit according to the above (4), wherein the inorganic filler is at least one member selected from the group consisting of aluminum oxide, aluminum nitride, boron nitride, silicon oxide (silica) and aluminum hydroxide.
(6) The LED light source unit according to any one of the above (1) to (5), wherein the adhesive tape contains glass cloth.
(7) The LED light source unit according to the above (1), wherein the adhesive tape comprises a silicone rubber sheet having a thermal conductivity of from 2 to 5 W/mK and an adhesive layer containing (meth)acrylic acid, formed on each side of the silicone rubber sheet, wherein the thickness of the silicone rubber sheet is from 100 to 300 µm, and the thickness of the adhesive layer formed on each side is from 5 to 40 µm.
(8) The LED light source unit according to any one of the above (1) to (7), wherein the adhesive strength between the adhesive tape and the fixing face of the printed board and the adhesive strength between the adhesive tape and the fixing face of the heat dissipating member, are from 2 to 10 N/cm.
(9) The LED light source unit according to any one of the above (1) to (8), wherein the printed board is a printed board comprising an insulating layer made of a composite material (prepreg) having a glass cloth base material impregnated with an epoxy resin, and a copper foil bonded to each side of the insulating layer, wherein a prescribed circuit pattern is formed on the copper foil, and through-holes are formed immediately below said LED mounted.
(10) The LED light source unit according to the above (9), wherein a plated conductor or a conductor is embedded in the through-holes.
(11) The LED light source unit according to any one of the above (1) to (8), wherein the printed board is a board having a conductor circuit provided on a metal base plate via an insulating layer comprising a thermoplastic resin or a thermosetting resin and having a thermal conductivity of from 1 to 4 W/mK, wherein the thickness of the metal base plate is from 100 to 500 µm, the thickness of the insulating layer is from 20 to 300 µm, and the thickness of the conductor circuit is from 9 to 140 µm.
(12) The LED light source unit according to the above (11), wherein the insulating layer comprises from 25 to 50 vol% of a thermoplastic resin or a thermosetting resin, and the rest being an inorganic filler which has a particle size of at most 100 µm and comprises coarse particles having an average particle size of from 10 to 40 µm and fine particles having an average particle size of from 0.4 to 1.2 µm and which has a sodium ion concentration of at most 500 ppm.
(13) The LED light source unit according to the above (11) or (12), wherein the chloride ion concentration in the thermoplastic resin or the thermosetting resin is at most 500 ppm.
(14) The LED light source unit according to any one of the above (11) to (13), wherein the thermoplastic resin is at least one fluororesin selected from the group consisting of a tetrafluoroethylene/perfluoroalkoxyethylene copolymer, a tetrafluoroethylene/hexafluoropropylene copolymer and a chlorotrifluoroethylene/ethylene copolymer.
(15) The LED light source unit according to any one of the above (11) to (13), wherein the thermosetting resin is at least one member selected from the group consisting of an epoxy resin, a phenol resin, a silicone resin and an acrylic resin.
(16) The LED light source unit according to any one of the above (11) to (13), wherein the thermosetting resin is a bisphenol A or bisphenol F epoxy resin, or a hydrogenated bisphenol A or bisphenol F epoxy resin.
(17) The LED light source unit according to any one of the above (11) to (13), wherein the thermosetting resin is a bisphenol A or bisphenol F epoxy resin, and contains a novolac resin as an epoxy-curing agent.
(18) The LED light source unit according to any one of the above (11) to (13), wherein the thermosetting resin is a hydrogenated bisphenol F or A epoxy resin and further contains a linear high molecular weight epoxy resin having an epoxy equivalent of from 800 to 4,000.

### EFFECTS OF THE INVENTION

According to the present invention, it is possible to effectively dissipate heat generated from an LED light source from the rear side of a printed board to a metal housing via an adhesive tape having electrical insulating properties and thermal conductivity. Specifically, even when a printed board having a circuit formed on each side is used, by securing electrical insulating properties and thermal conductivity by an adhesive tape having electrical insulating properties and thermal conductivity, it becomes possible to dissipate the heat to the exterior via the adhesive tape without necessity to protect with a coverlay film (such as a polyimide film) the circuit surface on the side to be fixed to the metal housing. Accordingly, it is possible to obtain effects to reduce heat accumulation on the LED-mounted board and to reduce the temperature rise of LED. It is thereby possible to provide an LED light source unit which is bright and has a long life and which is capable of suppressing the decrease in luminous efficiency of LED and able to prevent a damage to LED.

### BRIEF DESCRIPTION OF THE DRAWINGS

Fig. 1 is a cross-sectional view illustrating an embodiment of the LED light source unit according to the present invention.
Fig. 2 is a cross-sectional view illustrating another embodiment of the LED light source unit according to the present invention.

- 1:: LED
- 1a:: LED electrode terminal
- 2:: Base material
- 3:: Conductor circuit
- 4:: Rear side conductor circuit (lead wire)
- 5:: Solder connection
- 6:: Via hole (through-hole)
- 7:: Adhesive tape
- 8:: Housing
- 9:: Thermally conductive insulating layer
- 10:: Metal base plate

### BEST MODE FOR CARRYING OUT THE INVENTION

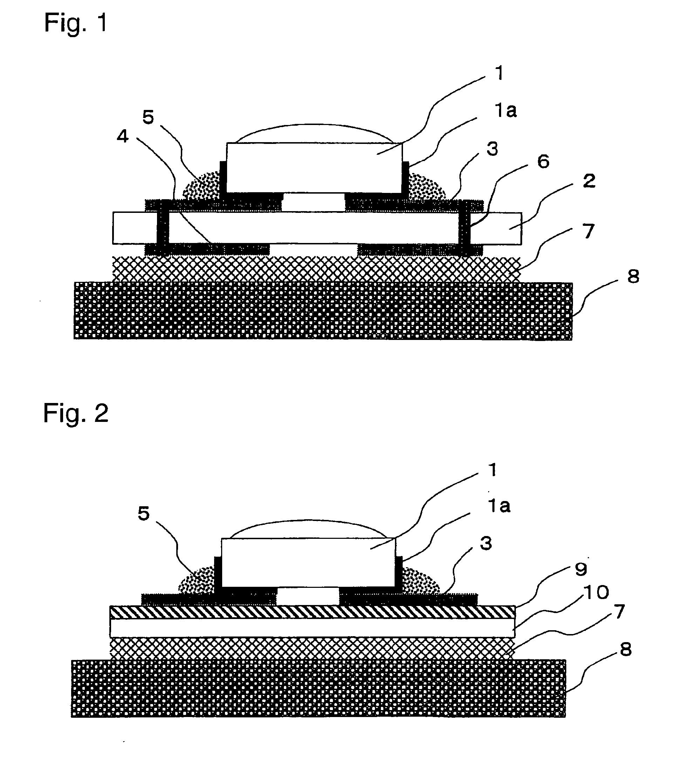

Fig. 1 is a cross-sectional view schematically illustrating the structure of one embodiment of the LED light source unit of the present invention.

The LED light source unit of the present invention has a printed board comprising a base material 2, a conductor circuit 3 and a rear side conductor circuit 4, wherein at least one LED 1 is mounted on the conductor circuit 3, as bonded by e.g. a solder connection 5, and is closely adhered to a housing 8 made of e.g. aluminum having heat dissipating properties via a thermally conductive adhesive tape 7 having electrical insulating properties. The conductor circuit 3 and the rear side conductor circuit 4 are electrically connected by via holes (or through-holes) 6, so that an electric power can be input to LED 1 from outside.

In Fig. 1, the printed board is, for example, one comprising an insulating layer made of a composite material (prepreg) having a glass cloth base material impregnated with an epoxy resin, and a copper foil bonded to each side of the insulating layer. On the above copper foil of the printed circuit, a prescribed circuit pattern is formed, and via holes 6 (through-holes) are formed immediately below the LED mounted.

The via holes 6 formed immediately below the LED mounted have a role of transmitting heat from LED to the rear side of the metal base material, and they are certainly required in a case where a printed board is employed which has an insulating layer made of a composite material (prepreg) having a glass cloth base material impregnated with an epoxy resin, and which has a copper foil bonded on each side of the insulating layer. It is particularly effective that the via holes 6 are formed by cylindrical copper for the purpose of increasing the heat dissipation performance.

The thermally conductive adhesive tape 7 is one having the thermal conductivity improved over conventional adhesive tapes in order to efficiently dissipate the heat generated during the light emission of LED from the rear side of the metal base material to the housing via the metal base material. With an adhesive tape having no thermal conductivity, the thermal conductivity of the heat generated at the time of light emission of LED to the housing tends to be inadequate, thus leading to an increase of the temperature of LED, such being practically not useful.

The thermally conductive adhesive tape to be used in the present invention has a thermal conductivity of from 1 to 4 W/mK, preferably from 3 to 4 W/mK, and the thickness of the adhesive tape is from 30 to 300 µm, preferably from 30 to 150 µm, more preferably from 30 to 50 µm.

The thermally conductive adhesive tape 7 to be used in the present invention is preferably one having a thermally conductive electrically insulating agent filled in a polymer resin material, as will be described hereinafter.

The polymer resin material to be used for the thermally conductive adhesive tape 7 of the present invention is not particularly limited. However, in order to improve the adhesion to metal, a polymer resin material is preferably selected which is made of a copolymer of acrylic acid and/or methacrylic acid (hereinafter referred to also as (meth)acrylic acid) and a monomer copolymerizable with such (meth)acrylic acid.

The above monomer copolymerizable with (meth)acrylic acid is preferably an acrylate or methacrylate having a C₂₋₁₂ alkyl group. From the viewpoint of the flexibility and processability, a preferred monomer may, for example, be one or more selected from ethyl acrylate, propyl acrylate, butyl acrylate, 2-ethyhexyl acrylate, octyl acrylate, isooctyl acrylate, decyl acrylate, decyl methacrylate and dodecyl methacrylate. Among them, a copolymer of a monomer containing a (meth)acrylic acid ester monomer is further preferred. As such a monomer, 2-ethylhexyl acrylate is particularly preferred.

The thermally conductive electrically insulating agent to be incorporated in the thermally conductive adhesive tape 7, is preferably contained in an amount of from 40 to 80 vol%, more preferably from 50 to 70 vol%, in the thermally conductive adhesive tape 7, since it is thereby possible to secure good heat dissipation performance. As such a thermally conductive electrically insulating agent, various inorganic fillers or organic fillers, which are excellent in electrical insulating properties and thermal conductivity, may be used.

An inorganic filler may, for example, be a metal oxide such as aluminum oxide (alumina), silicon oxide (silica) or titanium dioxide, a nitride such as aluminum nitride, boron nitride or silicon nitride, silicon carbide, or aluminum hydroxide. Among them, it is preferably at least one member selected from the group consisting of alumina, crystalline silica and aluminum hydroxide. Further, it is also possible to select one having the surface treated with e.g. a silane coupling agent. With respect to the particle size of the inorganic filler, the particle size is preferably at most 45 µm, particularly preferably from 20 to 40 µm, and the average particle size is preferably from 0.3 to 30 µm, particularly preferably from 10 to 20 µm, from the viewpoint of the thickness of the adhesive tape and the filling property.

As an organic filler, a rubber such as natural rubber, acrylic rubber, nitrile/butadiene rubber (NBR) or ethylenepropylenediene rubber (EPDM) is preferred. It is particularly preferred to contain acrylic rubber.

The acrylic rubber is preferably one made of a polymer of an acrylate or methacrylate having a C₂₋₁₂ alkyl group from the viewpoint of the flexibility and adhesive properties. For example, it may be a polymer of one monomer selected from ethyl acrylate, n-propyl acrylate, n-butyl acrylate, isobutyl acrylate, n-pentyl acrylate, isoamyl acrylate, n-hexyl acrylate, 2-methylpentyl acrylate, n-dodecyl acrylate, n-octadecyl acrylate, cyanomethyl acrylate, 1-cyanoethyl acrylate, 2-cyanoethyl acrylate, 1-aminopropyl acrylate and 2-cyanopropyl acrylate, or a polymer of a monomer mixture having at least two types of such monomers blended. Among them, a preferred monomer is 2-ethylhexyl acrylate.

By incorporating glass cloth to the thermally conductive adhesive tape 7, it is possible to remarkably improve the electrical insulating properties as well as the mechanical strength of the adhesive tape. The glass cloth is extremely effective since it not only provides the effect as a reinforcing material for the thermally conductive adhesive tape but also has an effect as a reinforcing material for an adhesive tape for bonding the housing and the printed board and is capable of preventing electrical short circuit which may otherwise occur when the bonding pressure to bond the housing and the printed board is so strong that the distance between the housing and the rear side of the printed board becomes too close. Namely, even if the bonding pressure at the time of bonding the housing and the printed board is too strong, the housing and the rear side of the printed board could not be closer than the thickness of the glass cloth, whereby the electrical characteristics can be secured.

As such glass cloth, glass fiber excellent in quality and cost produced by a direct melting method of spinning it directly from a melting furnace, is preferably employed. With respect to the composition of such glass fiber, preferred is one obtained by processing E glass (alumina/calcium borosilicate glass) as alkali free glass to be used for electrical applications, into long fiber. The glass cloth is preferably an electrically insulating non-woven fabric such as a wet system non-woven fabric of e.g. glass. The thickness of the glass cloth is preferably from 10 µm to 200 µm, more preferably from 20 µm to 50 µm. Further, in a case where glass cloth of glass long fiber made of alumina/calcium borosilicate glass is to be used, the electrical insulation reliability of the thermally conductive adhesive tape will be further improved, whereby the reliability of the LED light source unit will further be improved.

The thermally conductive adhesive tape 7 may contain a known polymer resin composition within a range not to impair the desired characteristics of the present invention. Further, at the time of curing the thermally conductive adhesive tape 7, an additive to control the viscosity or an additive such as a modifier, an aging-preventive agent, a heat stabilizer or a colorant, may be incorporated as the case requires, within a range not to present an adverse effect.

The thermally conductive adhesive tape 7 can be cured by a usual method. For example, it may be cured by a method such as thermal polymerization by means of a thermal polymerization initiator, photopolymerization by means of a photopolymerization initiator or polymerization by means of a thermal polymerization initiator and a curing accelerator. Among them, photopolymerization by means of a photopolymerization initiator is preferred from the viewpoint of the productivity, etc.

As specific forms of the thermally conductive adhesive tape 7, various types may be mentioned. For example, a thermally conductive adhesive tape may be mentioned which has an adhesive layer containing (meth)acrylic acid on each side of a silicon rubber sheet containing boron nitride particles and having a thermal conductivity of from 2 to 5 W/mK, wherein the thickness of the silicon rubber sheet is from 100 µm to 300 µm, and the thickness of the adhesive layer formed on each side is from 5 µm to 40 µm.

In the LED light source unit of the present invention, the adhesive strength between the thermally conductive adhesive tape 7 and the housing 8 as a heat dissipating member is preferably from 2 to 10 N/cm, more preferably from 4 to 8 N/cm. If the adhesive strength is lower than the above range, the adhesive tape tends to be easily peeled from the fixing face of the printed board or from the fixing face of the heat dissipating member. On the other hand, if the adhesive strength is higher than the above range, there will be a problem in handling efficiency, whereby the productivity may sometimes decrease, such being undesirable.

In the LED light source unit of the present invention, the withstand voltage between the rear side conductor circuit and the metal housing (i.e. the withstand voltage between the fixing face of the printed board and the fixing face of the heat dissipating member) is at least 1.0 V, preferably at least 1.5 V. When such withstand voltage is at least 1.0 V, insulation between the board and the metal housing can be attained. There is no upper limit for such withstand voltage, and the higher the withstand voltage, the better.

Fig. 2 is a cross-sectional view schematically illustrating the construction of another embodiment of the LED light source unit of the present invention having an insulating layer.

In the LED light source unit in Fig. 2, on a conductor circuit 3 of a printed board comprising the conductor circuit 3, an insulating layer 9 having thermal conductivity and a metal base plate 10, at least one LED 1 is mounted as bonded by e.g. solder and closely bonded to a housing 8 having heat dissipation properties via a thermally conductive adhesive tape 7.

In the LED light source unit in Fig. 2, the insulating layer 9 of the printed board having the metal base plate 10 has thermal conductivity, whereby heat generated from LED 1 is transferred to the metal base plate 10 via the insulating layer 9 and can be dissipated to the housing 8 having heat dissipating properties via the adhesive tape 7 having thermal conductivity. Therefore, it is possible to efficiently dissipate the heat generated from LED 1 to the housing 8 without providing via holes (through-holes) in the printed board as in Fig. 1.

Further, the printed board has the metal base plate 10, whereby even when the LED light source unit is continuously operated for more than 3,000 hours, the printed board will not be warped by the heat generation of LED, and there will be no such a problem that the adhesive tape peels or LED is displaced from the desired position to deteriorate the essential optical properties.

In the LED light source unit in Fig. 2, the thickness of the metal base plate 10 is from 100 to 500 µm, and the insulating layer 9 contains an inorganic filler and a thermoplastic resin or thermosetting resin and has a thickness of preferably from 20 to 300 µm, particularly preferably from 80 to 150 µm, and the thickness of the above conductor circuit is preferably from 9 to 140 µm, particularly preferably from 18 to 70 µm. With respect to the thickness of the insulating layer 9, if it is less than 20 µm, the insulating performance tends to be low, and if it exceeds 300 µm, the heat dissipation performance tends to be low.

As the metal base plate 10, it is possible to use copper or a copper alloy, an aluminum alloy, iron, stainless steel, having good thermal conductivity. The thickness of the metal base plate 10 is selected from a range of from 100 µm to 500 µm, preferably from 150 to 300 µm. If the thickness of the metal base plate 10 is less than 100 µm, the rigidity of the circuit board based on the metal base plate tends to be low, and its application tends to be limited, and it tends to be difficult to suppress warpage of the printed board when LED is continuously operated. If the thickness of the metal base plate 10 exceeds 500 µm, the thickness of the LED light source unit tends to be thick, such being undesirable.

The insulating layer 9 contains a thermoplastic resin and/or thermosetting resin in an amount of preferably from 25 to 50 vol%, more preferably from 30 to 45 vol%, and the rest being an inorganic filler.

The thermoplastic resin to be contained in the insulating layer 9 is preferably a heat resistant resin, and it is particularly preferred to use a fluororesin which may be heat-melted to be combined with an inorganic filler. Specifically, the fluororesin is at least one member selected from the group consisting of a tetrafluoroethylene/perfluoroalkoxyethylene copolymer, a tetrafluoroethylene/hexafluoropropylene copolymer and a chlorotrifluoroethylene/ethylene copolymer.

As the thermosetting resin to be contained in the insulating layer 9, an epoxy resin, a phenol resin, a silicone resin or an acrylic resin may, for example, be used. Among them, an epoxy resin is preferred, since such will be excellent in the adhesive strength with the metal base plate 10 and the conductor circuit 3 in the cured state while containing the inorganic filler, and it is excellent in heat resistance.

As a curing agent for the epoxy resin, any curing agent may be used without any particular restriction so long as it is capable of curing the above epoxy resin. However, a compound having a hydroxyl group is preferred from the viewpoint of the electrical characteristics of the obtainable cured product. As a specific example, it is possible to employ at least one member selected from the group consisting of an amine curing agent, an acid anhydride curing agent, a phenol curing agent and a dicyanamide. Particularly in consideration of the productivity and adhesion property, preferred is a phenol resin represented by a phenol novolac resin or a bisphenol A novolac resin having a softening point of at most 130°C. Further, in order to secure the rigidity, insulating property, etc. of the insulating layer, it is preferred to add such a resin so that the hydroxyl group equivalent will be preferably from 0.7 to 1.1 times, more preferably from 0.8 to 1.0 time, to the epoxy equivalent of the epoxy resin contained in the thermosetting resin.

The above epoxy resin is preferably a bisphenol A or bisphenol F epoxy resin. One having an epoxy equivalent of preferably at most 240, more preferably from 180 to 220, is suitable, since it is liquid at room temperature. Particularly, it is preferred to use a hydrogenated bisphenol A or bisphenol F epoxy resin, in order to improve the flexibility of the thermosetting resin after curing.

The hydrogenated bisphenol A or bisphenol F epoxy resin has a low viscosity, whereby it becomes possible to incorporate a linear high molecular weight epoxy resin having an epoxy equivalent of preferably from 800 to 4,000, particularly preferably from 1,000 to 2,000 to the thermosetting resin in a large amount at the maximum of 40 mass%, or to incorporate an inorganic filler in the insulating layer in an amount of as much as from 50 to 75 vol%.

It is preferred to incorporate the above linear high molecular weight epoxy resin having an epoxy equivalent of from 800 to 4,000, preferably from 1,000 to 2,000 to the insulating layer 9, whereby the bonding property will be improved, and the flexibility at room temperature will be improved. The content of such a linear high molecular weight epoxy resin is preferably at most 40 mass%, more preferably at most 30 mass% in the thermosetting resin. If it exceeds 40 mass%, the amount of the curing agent for the epoxy resin relatively decreases, whereby the glass transition temperature (Tg) of the thermosetting resin may be increased, and the flexibility may sometimes be decreased.

As the thermosetting resin constituting the insulating layer 9, a phenol resin, a polyimide resin, a phenoxy resin, an acrylic rubber, an acrylonitrile/butadiene rubber, etc. may be incorporated to the resin composed mainly of the above epoxy resin. Their amount is at most 30 mass%, preferably at most 20 mass%, based on the total amount with the epoxy resin, in consideration of the electrical insulating property, and thermal resistance, etc.

The thermoplastic resin constituting the insulating layer 9 may, for example, be polyethylene, polypropylene, polystyrene or a fluororesin. Among them, a fluororesin is preferred since, in addition to its characteristics that it is excellent in the thermal resistance, chemical resistance and weather resistance, it is excellent in the electrical insulating properties, and further, in its molten state, a thermally conductive filler can readily be dispersed therein.

The chloride ion concentration in the thermoplastic resin or thermosetting resin constituting the insulating layer 9 is preferably at most 500 ppm, more preferably at most 250 ppm. In the prior art, if the chloride ion concentration in the thermoplastic resin or the thermosetting resin composition is at most 1,000 ppm, the electrical insulating properties were good even at a high temperature under a DC voltage.

However, the thermoplastic resin or the thermosetting resin constituting the insulating layer 9 in the present invention has a flexible structure such that it can be bent even at room temperature, and therefore, if the chloride ion concentration exceeds 500 ppm, transfer of ionic impurities is likely to take place at a high temperature under a DC voltage, whereby the electrical insulating properties may tend to deteriorate. When the chloride ion concentration is low, it is possible to obtain an LED light source unit which is reliable over a long period of time.

The inorganic filler to be incorporated in the insulating layer 9 is preferably one having electrical insulating properties and is excellent in thermal conductivity. For example, silicon oxide (silica), preferably crystalline silica, alumina, aluminum nitride, silicon nitride or boron nitride may be used. The content of the inorganic filler in the insulating layer 9 is preferably from 50 to 75 vol%, more preferably from 55 to 70 vol%.

As the inorganic filler, preferred is one comprising coarse particles having a particle size of at most 100 µm and an average particle size of from 10 to 40 µm, preferably from 15 to 25 µm, and fine particles having an average particle size of from 0.4 to 1.2 µm, preferably from 0.6 to 1.1 µm. When such coarse particles and fine particles are mixed, higher packing will be possible, over a case where coarse particles or fine particles are used alone.

The sodium ion concentration in the inorganic filler is preferably at most 500 ppm, more preferably at most 100 ppm. If the sodium ion concentration in the inorganic filler exceeds 500 ppm, transfer of ionic impurities is likely to take place at a high temperature under a DC voltage, whereby the electrical insulating properties may tend to deteriorate.

The LED light source unit in Fig. 2 has the above-described construction, and the above-mentioned insulating layer comprises an inorganic filler and a thermosetting resin or thermoplastic resin and has a thickness of from 20 to 300 µm, preferably from 50 to 200 µm. The thickness of the conductor circuit is from 9 to 140 µm, preferably from 18 to 70 µm. Further, the thickness of the metal base plate is from 100 to 500 µm, preferably from 10 to 300 µm, the thickness of the above conductor circuit is from 9 to 140 µm, preferably from 18 to 70 µm, and the thermoplastic resin constituting the insulating layer contains a fluororesin.

As a preferred embodiment of the above insulating layer, one having a thermal conductivity of from 1 to 4 W/mK is used. Therefore, the LED light source unit of the present invention has high heat dissipation performance and withstand voltage characteristics as compared with an LED light source unit employing a conventional printed board, such that the withstand voltage between the conductor circuit and the metal foil is at least 1.5 kV. Accordingly, it is possible to efficiently dissipate the heat generated from the LED light source to the rear side of the board and further to the exterior, whereby heat accumulation in the LED-mounted board will be reduced, and the temperature rise may be reduced, and thus it is possible to suppress a decrease in the luminous efficiency of LED and thus prevent a damage to LED, and LED will be bright and have a long life.

When flexibility is required for the board, the glass transition temperature of the insulating layer is from 0 to 40°C. If the glass transition temperature is lower than 0°C, the rigidity and electrical insulating properties tend to be low, and if it exceeds 40°C, the flexibility tends to decrease. When the glass transition temperature is from 0 to 40°C, decrease of the withstand voltage due to peeling between the metal base plate 10 and the insulating layer 9 or due to cracking of the insulating layer, tends to hardly take place even if bend processing or drawing processing is carried out at room temperature, as is different from one which is hard at room temperature like an insulating layer used in a conventional metal base substrate.

### EXAMPLES

Now, the present invention will be described in further detail with reference to Examples and Comparative Examples. However, it should be understood that the present invention is by no means thereby restricted.

### EXAMPLE 1

An LED light source unit of the type shown in Fig. 1 was prepared. Namely, with a glass cloth-incorporated printed board having a copper foil with a thickness of 35 µm formed on each side of an epoxy resin cloth impregnated with a glass base material with a thickness of 100 µm, through-holes were formed at predetermined positions (positions to connect a conductor circuit connected to an electrode terminal 1 a of LED and a rear side conductor circuit located immediately therebelow) and copper-plated, and then, a conductor circuit on which LED is to be mounted, and a rear side conductor circuit to dissipate heat and to light up LED, were formed to obtain a printed board.

To 90 mass% of 2-ethylhexyl acrylate ("2EHA", manufactured by TOAGOSEI CO., LTD.) having 10 mass% of acrylic rubber ("AR-53L", manufactured by ZEON CORPORATION) dissolved therein, 10 mass% of acrylic acid ("AA", manufactured by TOAGOSEI CO., LTD.) was mixed. To the mixture, 0.5 mass% of a photopolymerization initiator 2,2-dimethoxy-1,2-diphenylethan-1-one (manufactured by Ciba Specialty Chemicals), 0.2 mass% of triethylene glycol dimercaptan (manufactured by Maruzen Chemical) and 0.2 mass% of 2-butyl-2-ethyl-1,3-propanediol diacrylate (manufactured by KYOEISHA CHEMICAL CO., LTD.) were further added and mixed to obtain a resin composition A.

Further, 80 mass% of a hydrogenated bisphenol A-type epoxy resin ("EXA-7015", manufactured by Dainippon Ink and Chemicals Incorporated) and 20 mass% of an aromatic polyamine ("H-84B" manufactured by Nippon Synthetic Chemical Industry Co., Ltd.) were mixed to obtain a resin composition B.

Then, 45 vol% of the resin composition A, 15 vol% of the resin composition B and 40 vol% of aluminum oxide having a particle size of at most 65 µm and an average particle size of 20 µm ("DAW-20", manufactured by Denki Kagaku Kogyo Kabushiki Kaisha) as an inorganic filler were mixed and dispersed to obtain a resin composition C.

The resin composition C subjected to defoaming treatment was applied on a PET (polyethylene terephthalate) film having a thickness of 75 µm and having release treatment applied on its surface, and a PET film having release treatment applied on its surface was further covered thereon, whereupon ultraviolet rays with a wavelength of 365 nm were applied from both sides with a dose of 3,000 mJ/cm². Thereafter, heat treatment was carried out at 100°C for 3 hours to cure the resin composition C thereby to obtain a thermally conductive adhesive tape having electrical insulating properties.

Then, cream solder (M705, manufactured by Senju Metal Industry Co., Ltd.) was applied by metal mask (screen printing) at a predetermined position of a conductor circuit of a printed board, and LED (NFSW036B, manufactured by Nichia Corporation) was mounted by means of a solder-reflow apparatus. Then, the thermally conductive adhesive tape having electrical insulating properties was bonded to the side of the printed board having no LED mounted, and fixed to a metal housing to obtain an LED light source unit.

With respect to the obtained LED light source unit, (1) the initial withstand voltage between the rear side conductor circuit and the metal housing, (2) the withstand voltage between the rear side conductor circuit and the metal housing after being left at a high temperature under high humidity, (3) the adhesive strength between the adhesive tape and the fixing face of the printed board, (4) the adhesive strength between the adhesive tape and the fixing face of the printed board after being left at high temperature under high humidity, (5) the adhesive strength between the adhesive tape and the fixing face of the heat dissipating member, (6) the adhesive strength between the fixing face of the printed board and the fixing face of the heat dissipating member after being left at high temperature under high humidity, (7) the thermal conductivity of the thermally conductive adhesive tape, (8) the initial LED lighting-up, (9) LED lighting-up after being left at high temperature under high humidity, and (10) the warpage of the board after continuous lighting-up, etc. were measured by the following methods. The obtained results are shown in Table 1.
(1) Initial withstand voltage between the rear side conductor circuit and the metal housing
   The withstand voltage between the rear side conductor circuit of the printed board and the metal housing was measured by a stepwise pressure-raising method stipulated by JIS C2110 in an environment at a temperature of 23°C with a humidity of 30%.
(2) Withstand voltage between the rear side conductor circuit and the metal housing after being left at high temperature under high humidity
   After being left for 1,000 hours in an environment at a temperature of 85°C with a humidity of 85%, the withstand voltage between the rear side conductor circuit of the printed board and the metal housing was measured by a stepwise pressure-raising method stipulated in JIS C2110 in an environment at a temperature of 23°C with a humidity of 30%.
(3) Adhesive strength between the adhesive tape and the fixing face of the printed board
   The adhesive strength between the adhesive tape and the printed board was measured by peeling the adhesive tape by a method stipulated in JIS C6481 in an environment at a temperature of 23°C with a humidity of 30%.
(4) Adhesive strength between the adhesive tape and the fixing face of the printed board after being left at high temperature under high humidity
   After being left for 1,000 hours in an environment at a temperature of 85°C with a humidity of 85%, the adhesive strength between the adhesive tape and the printed board was measured by peeling the adhesive tape by a method stipulated in JIS C6481 in an environment at a temperature of 23°C with a humidity of 30%.
(5) Adhesive strength between the adhesive tape and the fixing face of the heat dissipating member
   The adhesive strength between the adhesive tape and the fixing face of the heat dissipating member (aluminum housing) was measured by peeling the adhesive tape by a method stipulated in JIS C6481 in an environment at a temperature of 23°C with a humidity of 30%.
(6) Adhesive strength between the fixing face of the printed board and the fixing face of the heat dissipating member after being left at high temperature under high humidity
   After being left for 1,000 hours in an environment at a temperature of 85°C with a humidity of 85%, the adhesive strength between the adhesive tape and the fixing face of the heat dissipating member (aluminum housing) was measured by peeling the adhesive tape by a method stipulated in JIS C6481 in an environment at a temperature of 23°C with a humidity of 30%.
(7) Thermal conductivity of thermally conductive adhesive tape
   The test sample was laminated so that the thickness would be 10 mm and processed into 50 mm × 10 mm, whereupon the thermal conductivity was obtained by a quick thermal conductivity meter (QTM-500, manufactured by Kyoto Electronics Industry Co., Ltd.).
(8) Initial LED lighting-up test
   In an environment at a temperature of 23°C with a humidity of 30%, a rated current of 450 mA was applied to LED to light up LED, and upon expiration of 15 minutes, the temperature at the solder connection portion of LED was measured.
(9) LED lighting-up test after being left at high temperature under high humidity
   A LED light source unit was left for 1,000 hours in an environment at a temperature of 85°C with a humidity of 85%, and again, a rated current of 450 mA was applied to LED in an environment at a temperature of 23°C with a humidity of 30% to light up LED. Upon expiration of 15 minutes, the temperature of the solder connection portion of LED was measured.
(10) Warpage of the board after continuous lighting-up
   With respect to an LED light source unit, in an environment at a temperature of 23°C with a humidity of 30%, a current of 150 mA was applied to LED for 3,000 hours to continuously light up LED, whereupon warpage of the board (the position at 5 mm from the LED-mounted portion) was measured by means of a micrometer.

### EXAMPLE 2

An LED light source unit was prepared in the same manner as in Example 1 except for the following. Namely, as an inorganic filler, aluminum oxide ("DAW-10", manufactured by Denki Kagaku Kogyo Kabushiki Kaisha) was classified by a sieve of 45 µm to obtain an inorganic filler A having a maximum particle size of at most 45 µm and an average particle size of 9 µm. And, 40 vol% of the inorganic filler A, 45 vol% of the resin composition A and 15 vol% of the resin composition B were mixed to obtain a resin composition D.

Then, the resin composition D subjected to defoaming treatment was applied on a PET film having a thickness of 75 µm and having release treatment applied to its surface, and further, a PET film having release treatment applied to its surface was covered thereon, whereupon ultraviolet rays with a wavelength of 365 nm were applied to both sides at a dose of 3,000 mJ/cm². Thereafter, heat treatment was carried out at 100°C for 3 hours to cure the resin composition D thereby to obtain an electrically insulating thermally conductive adhesive tape having a thickness of 46 µm.

Then, cream solder (M705, manufactured by Senju Metal Industry Co., Ltd.) was applied by metal mask at a predetermined position of a conductor circuit of a printed board, and LED (NFSW036B, manufactured by Nichia Corporation) was mounted by means of a solder-reflow apparatus. Thereafter, the above-mentioned thermally conductive adhesive tape having electrical insulating properties was bonded to the side of the printed board having no LED mounted, and fixed to a metal housing thereby to obtain an LED light source unit.

Evaluation of the obtained LED light source unit was carried out in the same manner as in Example 1. The results are shown in Table 1.

### EXAMPLE 3

An LED light source unit was prepared in the same manner as in Example 1 except for the following.

Namely, using the same resin composition D as used in Example 2, the resin composition D subjected to defoaming treatment was applied in a thickness of 46 µm on a PET film having a thickness of 75 µm and having release treatment applied to its surface, and glass cloth having a thickness of 50 µm was laminated thereon, and further, a PET film having release treatment applied to its surface was covered and laminated thereon to impregnate the glass cloth with the resin composition D.

Then, ultraviolet rays of 365 nm were applied to both sides at a dose of 3,000 mJ/cm². Then, heat treatment was carried out at 100°C for 3 hours to cure the resin composition D thereby to obtain an electrically insulating thermally conductive adhesive tape having a thickness of 150 µm.

Then, cream solder (M705, manufactured by Senju Metal Industry Co., Ltd.) was applied by metal mask at a predetermined position of a conductor circuit of a printed board, and LED (NFSW036B, manufactured by Nichia Corporation) was mounted by means of a solder-reflow apparatus. Then, the thermally conductive adhesive tape having electrical insulating properties was bonded to the side of the printed board having no LED mounted, and fixed to a metal housing thereby to obtain an LED light source unit.

Evaluation of the obtained LED light source unit was carried out in the same manner as in Example 1. The results are shown in Table 1.

### EXAMPLE 4

An LED light source unit was prepared in the same manner as in Example 1 except for the following.

Namely, 100 parts by weight of a liquid silicone rubber ("CF-3110", manufactured by Dow Corning Toray Silicone Co., Ltd.), 200 parts by weight of a boron nitride (BN) powder having an average particle size of 9.5 µm and 20 parts by weight of toluene were mixed, adjusted and formed into a green sheet by a doctor blade method.

Thereafter, the green sheet was bonded to each side of a glass fiber cloth ("KS-1090", manufactured by Kanebo, Ltd.), and heated and vulcanized to obtain an insulating heat-dissipating sheet having a thickness of 200 µm.

On each side of the insulating heat-dissipating sheet, an acrylic adhesive agent was applied in a thickness of 20 µm to impart an adhesive property to each side thereby to obtain an electrically insulating thermally conductive adhesive tape.

Then, cream solder (M705, manufactured by Senju Metal Industry Co., Ltd.) was applied by metal mask at a predetermined position of a conductor circuit of a printed board, and LED (NFSW036B, manufactured by Nichia Corporation) was mounted by means of a solder-reflow apparatus. Then, the thermally conductive adhesive tape having electrical insulating properties was bonded to the side of the printed board having no LED mounted, and fixed to a metal housing thereby to obtain an LED light source unit.

Evaluation of the obtained LED light source unit was carried out in the same manner as in Example 1. The results are shown in Table 1.

### EXAMPLE 5

An LED light source unit shown in Fig. 2 was prepared. That is, to a fluororesin of a tetrafluoroethylene/hexafluoropropylene copolymer ("Neoflon FEP", manufactured by Daikin Industries, Ltd.), spherical coarse particles of aluminum oxide having a particle size of at most 75 µm and an average particle size of 21 µm and a sodium ion concentration of 10 ppm ("CB-A20", manufactured by Showa Denko K.K.) and spherical fine particles of aluminum oxide having an average particle size of 0.7 µm and a sodium ion concentration of 8 ppm ("AKP-15", manufactured by Sumitomo Chemical Co., Ltd.) were blended so that their total amount would be 66 vol% (mass ratio of spherical coarse particles to spherical fine particles being 7:3), and an insulating layer was formed on a copper foil having a thickness of 35 µm, so that the thickness would be 100 µm.

Then, on an aluminum foil having a thickness of 300 µm, the insulating layer formed as described above and a copper foil having a thickness of 35 µm were sequentially overlaid, followed by heat pressing at 200°C to bond the aluminum foil, insulating layer and copper foil to obtain a metal base substrate. The chloride ion concentration in the entire thermoplastic resin in the insulating layer of the metal base substrate was at most 300 ppm, and the sodium ion concentration in the entire inorganic filler in the insulating layer was at most 60 ppm.

With respect to the above metal base substrate, a predetermined position of the upper side copper foil surface was masked with an etching resist, and the copper foil was subjected to etching, and then, the etching resist was removed to form a circuit thereby to obtain a metal base circuit board.

Then, cream solder (M705, manufactured by Senju Metal Industry Co., Ltd.) was applied by metal mask at a predetermined position of the conductor circuit of the printed board, and LED (NFSW036AT, manufactured by Nichia Corporation) was mounted by means of a solder-reflow apparatus. Thereafter, the side of the metal base circuit board having no LED mounted was fixed to a U-shaped housing by the thermally conductive adhesive tape having a thermal conductivity of 1 W/mK and a thickness of 100 µm, obtained in Example 1, thereby to obtain an LED light source unit. Here, the thermally conductive adhesive tape is one prepared in the same manner as in Example 1 using the composition obtained in Example 1 except that aluminum oxide ("DAW-1 0", manufactured by Denki Kagaku Kogyo Kabushiki Kaisha) was packed in an amount of 400 parts by mass.

Evaluation of the obtained LED light source unit was carried out in the same manner as in Example 1. The results are shown in Table 1.

### EXAMPLE 6

An LED light source unit was prepared in the same manner as in Example 5 except for the following. That is, to 100 parts by mass of an epoxy resin comprising 70 mass% of a hydrogenated bisphenol A type epoxy resin having an epoxy equivalent of 207 ("EXA-7015", manufactured by Dainippon Ink and Chemicals Incorporated) and 30 mass% of a hydrogenated bisphenol A type epoxy resin having an epoxy equivalent of 1200 ("YL-7170", manufactured by Japan Epoxy Resins Co., Ltd.), 48 parts by mass of polyoxypropylenediamine (manufactured by HARTZMAN, mass ratio of "D-400" to "D-2000" being 6:4) was added as a curing agent, to prepare a thermosetting resin. To the thermosetting resin, an inorganic filler comprising 70 mass% of spherical coarse particles (aluminum oxide having a particle size of at most 75 µm, an average particle size of 21 µm and a sodium ion concentration of 10 ppm ("CB-A20", manufactured by Showa Denko K.K.)) and 30 mass% of spherical fine particles (aluminum oxide having an average particle size of 0.7 µm and a sodium ion concentration of 8 ppm ("AKP-15", manufactured by Sumitomo Chemical Co., Ltd.)) was blended so that the inorganic filler would be 50 vol%, to obtain a mixture.

Using this mixture, an insulating layer was formed on an aluminum foil having a thickness of 35 µm, so that the thickness after curing would be 100 µm. Then, the insulating layer was thermally set by heating to obtain a metal base substrate. The chloride ion concentration in the entire thermosetting resin in the insulating layer was at most 300 ppm, and the sodium ion concentration in the entire inorganic filler in the insulating layer was at most 50 ppm.

With respect to the above metal base substrate, a predetermined position was masked with an etching resist, and the copper foil was subjected to etching, and then, the etching resist was removed to form a circuit thereby to obtain a metal base circuit board.

Cream solder ("M705", manufactured by Senju Metal Industry Co., Ltd.) was applied by metal mask at a predetermined position of the conductor circuit of the metal base circuit board, and LED ("NFSW036AT", manufactured by Nichia Corporation) was mounted by means of a solder-reflow apparatus. Thereafter, the side of the metal base circuit board having no LED mounted was fixed to a U-shaped housing by a thermally conductive adhesive tape having a thermal conductivity of 2 W/mK and a thickness of 100 µm, as described hereinafter, to obtain an LED light source unit.

Here, the thermally conductive adhesive tape was one prepared in the same manner as in Example 1 by using the composition obtained in Example 1 except that aluminum oxide ("DAW-1 0", manufactured by Denki Kagaku Kogyo Kabushiki Kaisha) was packed in an amount of 400 parts by mass.

Evaluation of the obtained LED light source unit was carried out in the same manner as in Example 1. The results are shown in Table 1.

### EXAMPLE 7

An LED light source unit was prepared in the same manner as in Example 1 except for the following.

Namely, as an inorganic filler, an inorganic filler A having a maximum particle size of at most 45 µm and an average particle size of 9 µm was used, which was obtained by classifying aluminum oxide ("DAW-10", manufactured by Denki Kagaku Kogyo Kabushiki Kaisha) by means of a sieve of 45 µm. And, 50 vol% of the inorganic filler A, 40 vol% of the resin composition A and 10 vol% of the resin composition B were mixed to obtain a resin composition D.

Then, the resin composition D subjected to defoaming treatment was applied to a PET film having a thickness of 75 µm and having release treatment applied to its surface, and further, a PET film having release treatment applied to its surface was further covered thereon, whereupon ultraviolet rays with a wavelength of 365 nm was applied to each side at a dose of 3,000 mJ/cm². Thereafter, heat treatment was carried out at 100°C for 3 hours to cure the resin composition D thereby to obtain an electrically insulating thermally conductive adhesive tape having a thickness of 46 µm.

Then, cream solder (M705, manufactured by Senju Metal Industry Co., Ltd.) was applied by metal mask at a predetermined position of a conductor circuit of a printed board, and LED (NFSW036B, manufactured by Nichia Corporation) was mounted by means of a solder-reflow apparatus. Thereafter, the above-mentioned thermally conductive adhesive tape having electrical insulating properties was bonded to the side of the printed board having no LED mounted, and fixed to a metal housing to obtain an LED light source unit.

Evaluation of the obtained LED light source unit was carried out in the same manner as in Example 1. The results are shown in Table 1.

### EXAMPLE 8

An LED light source unit was prepared in the same manner as in Example 1 except for the following.

Namely, as an inorganic filler, an inorganic filler A having a maximum particle size of at most 45 µm and an average particle size of 9 µm was used, which was obtained by classifying aluminum oxide ("DAW-10", manufactured by Denki Kagaku Kogyo Kabushiki Kaisha) by means of a sieve of 45 µm. And, 70 vol% of the inorganic filler A, 25 vol% of the resin composition A and 5 vol% of the resin composition B were mixed to obtain a resin composition D.

Then, the resin composition D subjected to defoaming treatment was applied to a PET film having a thickness of 75 µm and having release treatment applied to its surface, and further, a PET film having release treatment applied to its surface was covered thereon, whereupon ultraviolet rays with a wavelength of 365 nm were applied to each side at a dose of 3,000 mJ/cm². Thereafter, heat treatment was carried out at 100°C for 3 hours to cure the resin composition D thereby to obtain an electrically insulating thermally conductive adhesive tape having a thickness of 46 µm.

Then, cream solder (M705, manufactured by Senju Metal Industry Co., Ltd.) was applied by metal mask at a predetermined position of a conductor circuit of a printed board, and LED (NFSW036B, manufactured by Nichia Corporation) was mounted by a solder-reflow apparatus. Thereafter, the above-mentioned thermally conductive adhesive tape having electrical insulating properties was bonded to the side of the printed board having no LED mounted, and fixed to a metal housing thereby to obtain an LED light source unit.

Evaluation of the obtained LED light source unit was carried out in the same manner as in Example 1. The results are shown in Table 1.

### EXAMPLE 9

An LED light source unit was prepared in the same manner as in Example 5 except for the following.

That is, to 100 parts by mass of an epoxy resin i.e. a bisphenol F type epoxy resin having an epoxy equivalent of 173 ("jer-808", manufactured by Japan Epoxy Resins Co., Ltd.), 45 parts by mass of a phenol novolac resin (manufactured by Dainippon Ink and Chemicals Incorporated, "TD2131") was added as a curing agent, to prepare a thermosetting resin. To the thermosetting resin, an inorganic filler comprising 80 mass% of coarse particles (silica having a particle size of at most 75 µm, an average particle size of 12 µm and a sodium ion concentration of 15 ppm ("A1", manufactured by Takamori K.K.)) and 20 mass% of fine particles (silica having an average particle size of 1.0 µm and a sodium ion concentration of 25 ppm ("5X", manufactured by Takamori K.K.)) was blended so that the inorganic filler would be 55 vol%, to obtain a mixture.

Using this mixture, an insulating layer was formed on a copper foil having a thickness of 35 µm, so that the thickness after curing would be 100 µm.

Then, the insulating layer was thermally set by heating to obtain a metal base substrate. The chloride ion concentration in the entire thermosetting resin in the insulating layer was at most 300 ppm, and the sodium ion concentration in the entire inorganic filler in the insulating layer was at most 50 ppm.

With respect to the above metal base substrate, a predetermined position was masked with an etching resist, and the copper foil was subjected to etching, and then, the etching resist was removed to form a circuit thereby to obtain a metal base circuit board.

Cream solder ("M705", manufactured by Senju Metal Industry Co., Ltd.) was applied by metal mask at a predetermined position of the conductor circuit of the metal base circuit board, and LED ("NFSW036B", manufactured by Nichia Corporation) was mounted by means of a solder-reflow apparatus. Thereafter, the side of the metal base circuit board having no LED mounted was fixed to a U-shaped housing by a thermally conductive adhesive tape having a thermal conductivity of 2 W/mK and a thickness of 100 µm, as described hereinafter, to obtain an LED light source unit.

Here, the thermally conductive adhesive tape was one prepared in the same manner as in Example 1 by using the composition obtained in Example 1 except that aluminum oxide ("DAW-10", manufactured by Denki Kagaku Kogyo Kabushiki Kaisha) was packed in an amount of 400 parts by mass.

Evaluation of the obtained LED light source unit was carried out in the same manner as in Example 1. The results are shown in Table 1.

### COMPARATIVE EXAMPLE 1

The same printed board as in Example 1 was used. Cream solder (M705, manufactured by Senju Metal Industry Co., Ltd.) was applied by metal mask at a predetermined position of a conductor circuit of a printed board, and LED (NFSW036AT, manufactured by Nichia Corporation) was mounted by means of a solder-reflow apparatus. Thereafter, an adhesive tape having a thickness of 250 µm ("Y-947", manufactured by Sumitomo 3M) was bonded to the side of the printed board having no LED mounted, and fixed to a metal housing thereby to obtain an LED light source unit.

Thereafter, in an environment at a temperature of 23°C with a humidity of 30%, a stabilized power source was connected to the obtained LED light source unit, and a current of 450 mA was applied to light up LED. The voltage at that time was 12.5 V. The temperature of the LED lighted up was measured by a thermocouple, whereby the temperature of LED was 70°C.

Thereafter, the LED light source unit was left for 1,000 hours in an environment at a temperature of 85°C with a humidity of 85%, and again, it was attempted to light up LED by connecting a stabilized power source to the LED light source unit in an environment at a temperature of 23°C with a humidity of 30%, but due to deterioration of the adhesive tape, short circuiting resulted between the rear side circuit of the printed board and the metal housing, and LED was not lighted up.

The LED light source unit was placed in an environment at a temperature of 23°C with a humidity of 30%, and a current of 150 mA was applied to LED for 3,000 hours to continuously light up LED, and warpage of the board thereafter (at a position 5 mm from the LED-mounted portion) was measured by a micrometer, and found to be 350 µm, and peeling was observed at an interface between the adhesive tape and the face of the printed board having no LED mounted.

These results are shown in Table 1.

**TABLE 1**

| | Withstand voltage between rear side circuit and metal housing | | Adhesive strength between adhesive tape and fixing face of printed board | | Adhesive strength between adhesive tape and fixing face of heat dissipating member | | Thermal conductivity of adhesive tape stage (W/mk) | LED lighting-up test (temperature of the joint portion of LED) | | Warpage of the board after continuous lighting-up (mm) |
|---|---|---|---|---|---|---|---|---|---|---|
| | Initial stage (kV) | After being left at high temperature under high humidity (kV) | Initial stage (N/cm) | After being left at high temperature under high humidity (N/cm) | Initial stage (N/cm) | After being left at high temperature under high humidity (N/cm) | | Initial stage(°C) | After being left at high temperature under high humidity (°C) | |
| Ex. 1 | 4.0 | 3.5 | 7.0 | 7.2 | 8.0 | 8.1 | 1.0 | 57 | 56 | 0.20 |
| Ex. 2 | 3.0 | 2.5 | 4.0 | 4.1 | 4.5 | 4.6 | 1.1 | 44 | 47 | 0.18 |
| Ex. 3 | 5.0 | 4.9 | 5.0 | 5.2 | 7.0 | 7.1 | 1.0 | 55 | 59 | 0.20 |
| Ex. 4 | 5.1 | 5.0 | 3.0 | 3.1 | 4.0 | 4.2 | 3.0 | 43 | 44 | 0.17 |
| Ex. 5 | 4.0 | 3.5 | 7.0 | 7.2 | 8.0 | 8.2 | 1.0 | 55 | 57 | 0.80 |
| Ex. 6 | 4.0 | 3.5 | 7.0 | 7.2 | 8.0 | 8.2 | 1.0 | 54 | 56 | 0.50 |
| Ex. 7 | 3.5 | 3.0 | 6.0 | 6.2 | 7.0 | 7.1 | 1.0 | 5 | 55 | 0.20 |
| Ex. 8 | 3.0 | 2.5 | 4.0 | 4.4 | 4.5 | 4.6 | 3.8 | 40 | 42 | 0.17 |
| Ex. 9 | 5.5 | 5.0 | 7.0 | 7.1 | 7.8 | 8.3 | 1.1 | 51 | 52 | 0.17 |
| Comp. Ex. 1 | 2.6 | 0.0 (NG) | 3.5 | 1.5 | 4.0 | 1.8 | 0.6 | 70 | - | 0.35 |

### INDUSTRIAL APPLICABILITY

The LED light source unit of the present invention has improved heat dissipation properties and thus is capable of efficiently dissipating the heat generated from the LED light source to the rear side of the board and further to the exterior, whereby it is possible to reduce accumulation of the heat in the LED-mounted board and to reduce the temperature rise of LED.

As a result, it is capable of suppressing a decrease of the luminous efficiency of LED and preventing a damage to LED and is free from such a problem that during continuous lighting-up of LED, the printed board is warped under an influence of the heat generated from LED, the printed board is peeled from the adhesive tape, or LED is displaced from the desired position for light emission whereby the desired optical characteristics can not be obtained; it is bright and has a long life; and it has a characteristics that highly heat generative LED can be mounted. Thus, it can be applied to various application fields and thus is industrially useful.

The entire disclosure of Japanese Patent Application No. 2007-019755 filed on January 30, 2007 including specification, claims, drawings and summary is incorporated herein by reference in its entirety.

## Claims

1. An LED light source unit comprising a printed board, at least one light emitting diode (LED) provided on the printed board, and an adhesive tape for fixing the printed board on the surface of a heat dissipating member, wherein the thermal conductivity of the adhesive tape is from 1 to 4 W/mK, and the withstand voltage between a rear side conductor circuit and a metal housing is at least 1.0 kV.

2. The LED light source unit according to Claim 1, wherein the thickness of the adhesive tape is from 30 to 300 µm.

3. The LED light source unit according to Claim 1, wherein the thickness of the adhesive tape is from 30 to 50 µm.

4. The LED light source unit according to any one of Claims 1 to 3, wherein the adhesive tape comprises from 20 to 45 vol% of a polymer resin material made of a copolymer of (meth)acrylic acid with a monomer copolymerizable with (meth)acrylic acid, and from 40 to 80 vol% of an inorganic filler having a particle size of at most 45 µm and an average particle size of from 0.3 to 30 µm.

5. The LED light source unit according to Claim 4, wherein the inorganic filler is at least one member selected from the group consisting of aluminum oxide, aluminum nitride, boron nitride, silicon oxide (silica) and aluminum hydroxide.

6. The LED light source unit according to any one of Claims 1 to 5, wherein the adhesive tape contains glass cloth.

7. The LED light source unit according to Claim 1, wherein the adhesive tape comprises a silicone rubber sheet having a thermal conductivity of from 2 to 5 W/mK and an adhesive layer containing (meth)acrylic acid, formed on each side of the silicone rubber sheet, wherein the thickness of the silicone rubber sheet is from 100 to 300 µm, and the thickness of the adhesive layer formed on each side is from 5 to 40 µm.

8. The LED light source unit according to any one of Claims 1 to 7, wherein the adhesive strength between the adhesive tape and the fixing face of the printed board and the adhesive strength between the adhesive tape and the fixing face of the heat dissipating member, are from 2 to 10 N/cm.

9. The LED light source unit according to any one of Claims 1 to 8, wherein the printed board is a printed board comprising an insulating layer made of a composite material (prepreg) having a glass cloth base material impregnated with an epoxy resin, and a copper foil bonded to each side of the insulating layer, wherein a prescribed circuit pattern is formed on the copper foil, and through-holes are formed immediately below said LED mounted.

10. The LED light source unit according to Claim 9, wherein a plated conductor or a conductor is embedded in the through-holes.

11. The LED light source unit according to any one of Claims 1 to 8, wherein the printed board is a board having a conductor circuit provided on a metal base plate via an insulating layer comprising a thermoplastic resin or a thermosetting resin and having a thermal conductivity of from 1 to 4 W/mK, wherein the thickness of the metal base plate is from 100 to 500 µm, the thickness of the insulating layer is from 20 to 300 µm, and the thickness of the conductor circuit is from 9 to 140 µm.

12. The LED light source unit according to Claim 11, wherein the insulating layer comprises from 25 to 50 vol% of a thermoplastic resin or a thermosetting resin, and the rest being an inorganic filler which has a particle size of at most 100µm and comprises coarse particles having an average particle size of from 10 to 40 µm and fine particles having an average particle size of from 0.4 to 1.2 µm, and which has a sodium ion concentration of at most 500 ppm.

13. The LED light source unit according to Claim 11 or 12, wherein the chloride ion concentration in the thermoplastic resin or the thermosetting resin is at most 500 ppm.

14. The LED light source unit according to any one of Claims 11 to 13, wherein the thermoplastic resin is at least one fluororesin selected from the group consisting of a tetrafluoroethylene/perfluoroalkoxyethylene copolymer, a tetrafluoroethylene/hexafluoropropylene copolymer and a chlorotrifluoroethylene/ethylene copolymer.

15. The LED light source unit according to any one of Claims 11 to 13, wherein the thermosetting resin is at least one member selected from the group consisting of an epoxy resin, a phenol resin, a silicone resin and an acrylic resin.

16. The LED light source unit according to any one of Claims 11 to 13, wherein the thermosetting resin is a bisphenol A or bisphenol F epoxy resin, or a hydrogenated bisphenol A or bisphenol F epoxy resin.

17. The LED light source unit according to any one of Claims 11 to 13, wherein the thermosetting resin is a bisphenol A or bisphenol F epoxy resin, and contains a novolac resin as an epoxy-curing agent.

18. The LED light source unit according to any one of Claims 11 to 13, wherein the thermosetting resin is a hydrogenated bisphenol F or A epoxy resin and further contains a linear high molecular weight epoxy resin having an epoxy equivalent of from 800 to 4,000.
